# FASCICULE DE BREVET EUROPEEN

(11) **EP 0 503 730 B1**
(45) Date de publication et mention de la délivrance du brevet: **07.01.1999**
(21) Numéro de dépôt: 92200653.1
(22) Date de dépôt: 06.03.1992
(51) Int. Cl.: G06K 19/077

(54) **Carte à microcircuit**
Karte mit Mikroschaltkreis
Microcircuit card

(30) Priorité: 15.03.1991 FR 9103197
(43) Date de publication de la demande: 16.09.1992
(73) Titulaire: Koninklijke Philips Electronics N.V., 5621 BA Eindhoven (NL)
(72) Inventeur: Venambre, Jacques, Société Civile S.P.I.D., F-75008 Paris (FR); Molko, Henri, Société Civile S.P.I.D., F-75008 Paris (FR)
(74) Mandataire: Pyronnet, Jacques

(56) Documents cités:
- EP-A- 0 246 893
- EP-A- 0 344 058
- EP-A- 0 376 062
- FR-A- 2 617 668
- FR-A- 2 621 147
- PATENT ABSTRACTS OF JAPAN vol. 11, no. 62 (P-551)(2509), 25 février 1987; & JP - A - 61226887 (ANRITSU) 08.10.1986

## Description

La présente invention a pour objet une carte à microcircuit comportant un support de carte présentant un logement dans lequel est fixée une vignette, ladite vignette présentant un support de circuit et au moins un circuit (en général un circuit intégré) disposé sur une face inférieure du support de circuit dirigée vers l'intérieur du logement, le circuit étant disposé en regard d'une portion d'un fond du logement, le support de circuit comportant sur sa face inférieure au moins un élément de transfert d'énergie disposé en regard d'une deuxième portion du fond du logement espacée de ladite première portion.

De telles cartes à microcircuit du type comportant des contacts électriques, connues de la demande de brevet français FR-A-2 617 668 déposée le 03/07/1987, sont susceptibles d'être utilisées dans des applications diverses (inscription de données personnalisées, transactions bancaires, paiement etc...) et sont fournies à cet effet à toutes sortes d'utilisateurs.

En particulier, la demande de brevet EP-A 0 376 062 divulgue la fabrication d'un module électronique pour, notamment, une telle carte. Dans ce module, une bobine est disposée autour du circuit. Le module achevé constitue un bloc rigide, avant sa pose dans l'objet portatif (carte) (voir le préambule de la revendication 1).

Il est connu par ailleurs des cartes à microcircuit sans contact (par exemple selon la demande de brevet français n° 2 621 147 publiée le 31 mars 1989). Selon cette antériorité, une carte de type connu (fig.7 et 8) comporte un microcircuit, et des bobines électro-magnétiques constituant des éléments de transfert d'énergie qui sont montés sur un circuit imprimé. La pastille de microcircuit et les bobines électro-magnétiques sont enfermées, ensemble avec la plaquette de circuit imprimé, dans un boîtier de protection ou corps de carte en résine diélectrique ou analogue. Une telle fabrication est coûteuse.

La présente invention propose de réaliser une carte à mircocircuit du type dit "sans contact" avec la technologie précitée mettant en oeuvre une vignette, connue pour les cartes à microcircuit du type "avec contact".

Dans ce but, une carte à microcircuit est caractérisée en ce que la deuxième portion est disposée au voisinage d'un bord latéral du logement et que le fond présente au moins une partie amincie située entre la première et la deuxième portion.

Selon un mode de réalisation préféré, le support de circuit est un circuit imprimé souple, l'élément de transfert d'énergie étant dessiné sur celui-ci.

De la sorte, le support de circuit et l'élément de transfert d'énergie peuvent suivre les déplacements du support de carte lors de contraintes mécaniques appliquées sur celle-ci.

Au moins un élément de transfert d'énergie peut être une bobine.

Au moins une partie de la deuxième portion du fond du logement peut présenter une surépaisseur, de préférence telle que l'élément de transfert d'énergie est pratiquement en contact avec celle-ci.

Par ailleurs, la demande de brevet français n° 2 662 000 déposée par la Demanderesse le 11 mai 1990 et la demande correspondante EP-A-0 456 323, publiée le 13.11.91, propose d'améliorer les conditions mécaniques relatives aux retransmissions de contraintes au microcircuit en particulier lors de déformations mécaniques de la carte, et donc d'augmenter la fiabilité de la carte. Une telle carte selon l'invention peut également être réalisée de manière à incorporer cette amélioration. Le fond présente alors au moins une partie amincie située au moins en majeure partie en dehors de ladite portion. Une telle partie amincie constitue un piège de déformations et la partie du fond du logement qui est située en regard du circuit, constitue un pilier, l'ensemble permettant de diminuer les contraintes auxquelles est soumis le circuit.

L'invention sera mieux comprise à la lecture de la description qui va suivre, donnée à titre d'exemple non limitatif, en liaison avec les dessins ci-annexés dans lesquels :
- la figure 1 représente une carte électronique selon l'art antérieur précité,
- les figures 2a et 2b représentent en coupe longitudinale respectivement une carte et un support de carte selon l'invention, ce dernier selon un mode préféré,
- les figures 3a et 3b illustrent les phénomènes de déformation d'une carte dont le support de carte est selon la figure 2b,
- les figures 4a et 4b représentent une vue agrandie du logement selon l'invention ménagé dans la carte respectivement sans et avec vignette,
- et les figures 5 et 6 représentent des variantes de logement.

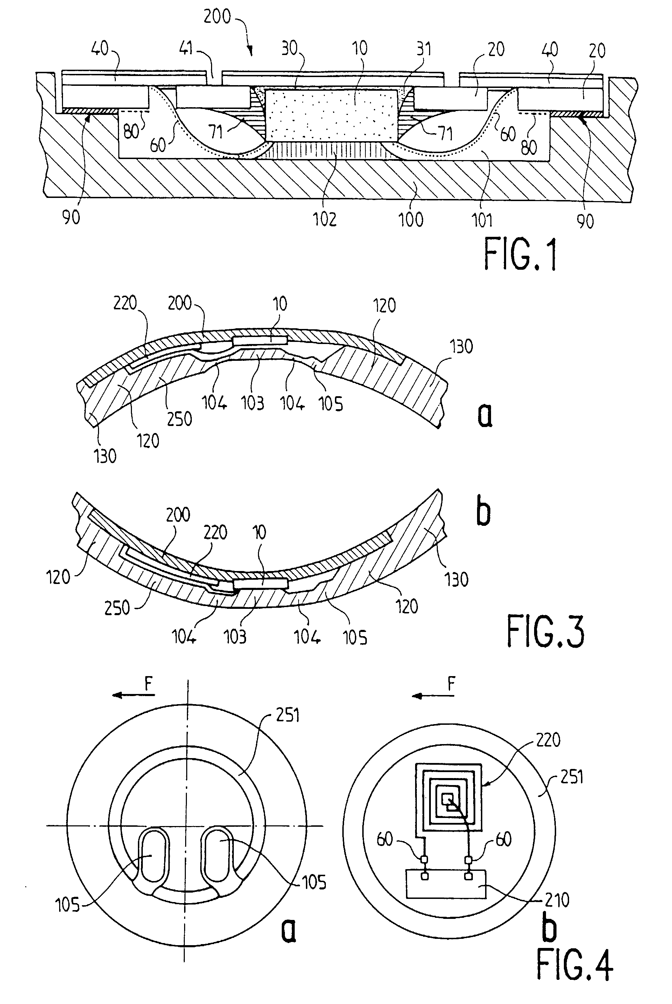

Selon la figure 1, une carte à microcircuit comporte une vignette 200, présentant un support de circuit (20, 40) et un circuit 10, et fixée dans un logement 101, le circuit 10 étant disposé sur une face inférieure du support de circuit (20, 40) de telle sorte que le circuit 10 est disposé à l'intérieur du logement 101 et fait face au fond 100 du logement 101. Le circuit 10 est collé de manière classique par une colle conductrice (30, 31) sur le support de circuit (20, 40) et des fils de connexion 60 sont soudés entre le circuit 10 et le support de circuit (20, 40), lequel présente des couches conductrices disposées de manière à réaliser les connexions nécessaires. Le support de circuit présente ici une couche conductrice 40 en l'espèce une feuille de cuivre sur laquelle ont été déposées électrolytiquement une couche de Ni, puis une couche d'Au, et une couche isolante 20, l'ensemble formant un support souple. La couche 40 présente des ouvertures 41 la séparant électriquement en différentes zones permettant d'isoler les prises de contact électrique. Des fils de connexion 60 sont mis en place par ultra-sons entre la face supérieure de la pastille 10 et lesdites zones. Des zones 71 en résine époxy présentant un profil progressif peuvent être disposées pour renforcer la tenue mécanique. On trouvera une description plus détaillée de cette mise en oeuvre dans la demande de brevet français FR 2 580 416 déposée le 12/04/1985.

La vignette, obtenue après découpe, est retournée et collée en 90 dans le logement 101. En 90, un adhésif double face pelable peut être mis en oeuvre selon la demande de brevet FR 2 580 416 précitée, la couche pelable pouvant servir de masque à un vernis de protection 80.

Enfin, un collage en 102 est réalisé par une couche de résine polyuréthane, relativement dure, de manière à obtenir une bonne rigidité mécanique de l'ensemble. Une telle résine est par exemple le DAMIVAL 13521 fabriqué par ALSTHOM présentant une dureté nominale de 85 SHORE D2 après polymérisation. Les résines de la famille DAMIVAL sont considérées par le fabricant comme rigides pour une dureté de 90 SHORE D2, semi-rigides pour une dureté de 85 SHORE D2 (comme ci-dessus), et souples pour une dureté de 50 SHORE D2.

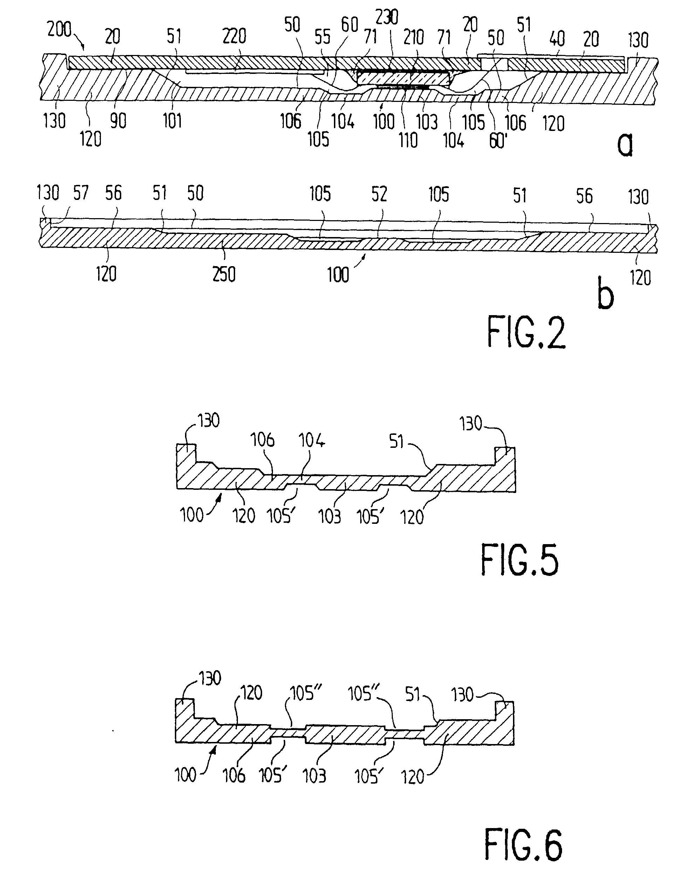

Selon les figures 2a et 2b, les soudures fil 60 forment un contact électrique entre le circuit 210 collé en 230 sur la surface inférieure d'un circuit imprimé, notamment souple, référencé 20, et une bobine 220 dessinée sur le circuit imprimé 20. En option, on a représenté un contact 40 sur la face supérieure du circuit imprimé, mais il est bien entendu qu'il est plus normalement envisagé de ne métalliser le circuit imprimé que sur sa face inférieure. On peut utiliser l'adhésif double face 90, mais le reste des étapes de mise en place est beaucoup plus simple.

Selon un mode de réalisation correspondant à la demande n° 2 662 000 précitée, la face interne 50 du fond 100 du logement 101 d'un support de carte 130 est rainuré en 105, ici selon deux rainures situées en majeure partie de part et d'autre du circuit 10 et définissant deux régions amincies 104, laissant subsister une partie 103 plus épaisse faisant face à une majeure partie du circuit 10.

On notera un chanfrein 51 entre le fond 56 de l'embrèvement de contour extérieur 57 où le collage de la vignette 200 est réalisé et le logement 101 proprement dit. Un chanfrein 51 délimite l'extérieur du logement 101 et forme une transition entre une partie externe 106 du fond 100 et la région 120 du support de carte 130 où est réalisé l'embrèvement. Une couche résiliente 110 peut être disposée entre le circuit 210 et la face interne 52 de la partie centrale 103 du fond 100 du logement 101. Sa fonction sera explicitée par la suite. On remarquera également que l'on a mis à profit la présence des rainures 105 pour absorber au moins en partie la surépaisseur des fils 60 et 60' par rapport au circuit 210 au voisinage de la soudure fil en 61 sur la face principale du circuit 210 tournée vers le fond 100. Ceci permet un gain de place non négligeable. De fait, la partie centrale 103 est plus étroite que la portion du fond 100 qui fait face au circuit 210 (et donc que le circuit 210) pour laisser un dégagement au fil (60, 60') au voisinage de la soudure fil 61.

Selon la figure 2b, le fond 100 présente une région de surépaisseur 250 qui est située sensiblement en regard de la bobine 220 et est de préférence pratiquement en contact mécanique avec celle-ci (aux tolérances près).

Les figures 5 et 6 montrent enfin deux variantes de réalisation. Des rainures 105' peuvent être disposées sur la face du support de carte opposée au logement 101 (fig.5), ou bien des rainures 105' et 105" peuvent être disposées simultanément sur la face interne du logement 101 et sur la face du support de carte opposée au logement 101 (fig.6). Les rainures peuvent également être omises, et donc les parties amincies 104.

En se reportant plus particulièrement aux figures 3a et 3b, on va maintenant expliquer l'influence, lors d'une flexion de la carte, des parties amincies 104, et de la région de surépaisseur 250, lesquelles peuvent être présentées en combinaison ou séparément, ou bien omises.

Selon la figure 3a, la vignette 200 est en extension, et la face interne 52 du fond 50 tend à être plaquée contre le circuit 10. Les parties amincies 104 plient et absorbent ainsi une grande partie des déformations, ce qui fait que la partie 103, soit n'appuie pas contre le circuit, soit pour une flexion importante de la carte, appuie contre le circuit 10 en ne retransmettant à celui-ci qu'une partie seulement des contraintes, ce qui a pour effet d'augmenter la fiabilité de la carte lors de flexions répétées. Dans le cas de la fig. 3a, la fonction des parties amincies 104 est de servir de piège de déformations pour éviter que la partie centrale 103 ne retransmette des contraintes trop élevées au circuit 10. Dans le cas où il existe la surépaisseur 250, cette dernière protège la bobine 220 Lorsque la vignette 200 est en extension, car celle-ci épouse le contour de la surépaisseur 250.

Selon la figure 3b, la vignette 200 est en compression et le circuit 10 vient s'appuyer contre la partie centrale 103 formant un pilier (ou une poutre), qui se déplace par translation grâce aux parties amincies 104. De ce fait, les contraintes subies par le circuit 10 sont diminuées, tout en maintenant les déformations du fond 50 du logement 101 dans des limites raisonnables. Le fonctionnement en pilier de la partie 103 permet en particulier une plus grande surface de contact entre celle-ci et le circuit 10 car les déformations sont subies essentiellement par les parties amincies 104 et la partie 103 reste relativement plane. En pratique, on donnera à la partie centrale 103 l'épaisseur maximale compatible avec les tolérances sur l'épaisseur de la carte et une surface égale à celle du circuit 10, sauf passage éventuel des fils 60. On aura tout intérêt à réaliser les parties amincies 104 avec la largeur la plus grande et l'épaisseur la plus faible compatible avec des tests de flexions répétées. Dans le cas où existe la région de surépaisseur 250, cette dernière protège la bobine 220 lorsque la vignette 200 est en compression, car celle-ci épouse également dans ce cas le contour de la région de surépaisseur 250.

### Exemple :

Une carte bancaire en chlorure de polyvinyle (PVC) chargé de TᵢO₂ selon le standard ISO de longueur nominale 85,6 mm et de largeur nominale 53,98 mm et d'épaisseur nominale 810 microns présente un logement de diamètre total 57 environ 16,2 mm, le diamètre au bord du chanfrein 51 étant de 12 mm. Le fond 50 du logement 101 présente une épaisseur de 300 microns, les parties amincies 104 présentant une épaisseur de 200 microns, une longueur de 3,5 mm et une largeur de 2,5 mm, le pilier 103 ayant une largeur de 2,5 mm. Il existe une tolérance nominale de 50 microns entre le circuit 10 et la partie centrale 103. Le circuit imprimé 20 a une épaisseur de 125 microns, et la (ou les) bobine(s) 220 est réalisée en un conducteur d'environ 70 microns d'épaisseur. La région de surépaisseur 250 peut avoir une épaisseur atteignant environ 550 microns.

La couche résiliente 110, éventuellement présente, peut être réalisée en silicone RTV3140 fabriqué par DOW CORNING et présentant une dureté de 20 à 30 SHORE D2 suivant les conditions, notamment hygrométriques, de vulcanisation. En conservant les critères d'évaluation utilisés ci-dessus pour les résines, on pourrait qualifier le RTV3140 de "très souple". Elle permet d'obtenir un amortissement dynamique des contraintes transmises entre le circuit 10 et la partie centrale 103 du fond 50, venant ainsi apporter un complément à l'effet des parties amincies 104. La couche résiliente 110 ne doit pas être trop déformable de manière à remplir sa fonction d'amortissement, mais suffisamment déformable pour éviter une rigidification de l'ensemble qui serait favorable à la transmission de contraintes au microcircuit. Ce sont les tests en flexion qui permettent de déterminer la résilience optimale de la couche 110.

Une telle carte, mais de préférence avec une couche résiliente 110, présente de bonne propriétés en cas de lecture magnétique de pistes magnétiques chevauchant partiellement le logement 101. Dans ce cas, la partie centrale 103 forme un pilier dont la rigidité permet d'éviter des déformations trop importantes entraînant des affaiblissements trop importants ("drop out") du signal. Comme il n'y a pas de couche rigide 102, les déformations de la vignette induites éventuellement par un galet qui roule sur celle-ci lors d'une lecture-écriture magnétique ne sont retransmises au circuit 10 qu'au-delà d'un certain seuil. Il est particulièrement recommandé de laisser la tolérance la plus faible possible entre le circuit 10 et la partie centrale 103 de manière que cette dernière soit la plus épaisse possible et donc la plus rigide possible, ce qui est également favorable dans le cas de flexions illustrées aux figures 3a et 3b.

D'autres modes de réalisation peuvent être mis en oeuvre. Le circuit 10 n'est pas forcément disposé au centre du logement 101 qui peut avoir des formes autres que circulaires. Un logement 101 peut ne compter qu'une seule partie amincie 104, en particulier dans le cas où le circuit 10 jouxterait un bord du logement. Les rainures 105, 105' et 105" lorsqu'elles existent pourraient être par exemple réalisées par moulage.

La figure 4a représente les rainures 105 réalisées par usinage et occupant une partie de la vignette, de manière à laisser la place à la bobine 220 (figure 2b). La bobine 220 est disposée de préférence près d'un bord transversal de la vignette (la flèche F indique la direction longitudinale de la carte).

## Revendications

1. Carte à microcircuit comportant un support de carte (130) présentant un logement (101) dans lequel est fixée une vignette, ladite vignette présentant un support de circuit (20) et au moins un circuit (210) disposé sur une face inférieure du support de circuit (20) dirigée vers l'intérieur du logement, le circuit étant disposé en regard d'une première portion (103) d'un fond du logement, le support de circuit (20) comportant sur sa face inférieure au moins un élément de transfert d'énergie (220) disposé en regard d'une deuxième portion du fond du logement espacée de ladite première portion, caractérisée en ce que la deuxième portion est disposée au voisinage d'un bord latéral du logement et que le fond présente au moins une partie amincie (104) située entre la première (103) et la deuxième portion.

2. Carte selon la revendication 1, caractérisée en ce que le support de circuit (20) est un circuit imprimé souple, l'élément de transfert d'énergie étant dessiné sur celui-ci.

3. Carte selon une des revendications 1 ou 2, caractérisée en ce qu'au moins un élément de transfet d'énergie (220) est une bobine.

4. Carte selon une des revendications 1 à 3, caractérisée en ce que au moins une partie de la deuxième portion du fond du logement présente une région de surépaisseur (250) telle que l'élément de transfert d'énergie (220) est pratiquement en contact avec celle-ci.

## Patentansprüche

1. Mikroschaltkreis-Karte mit einem Kartenträger (130), der eine Lagerung (101) aufweist, in der eine Klebefolie befestigt ist, welche Folie einen Schaltungsträger (20) und zumindest eine Schaltung (210) aufweist, die auf einer dem Inneren der Lagerung zugewandten, unteren Fläche des Schaltungsträgers (20) angeordnet ist, wobei die Schaltung gegenüber einem ersten Abschnitt (103) eines Lagerungsbodens angeordnet ist, wobei der Schaltungsträger (20) auf seiner unteren Fläche zumindest ein Energieübertragungslement (220) umfaßt, das gegenüber einem zweiten Abschnitt des Lagerungsbodens auf Abstand von dem genannten ersten Abschnitt angeordnet ist, dadurch gekennzeichnet, daß der zweite Abschnitt in der Nähe eines seitlichen Randes der Lagerung angeordnet ist und daß der Boden zumindest einen zwischen dem ersten (103) und dem zweiten Abschnitt liegenden verdünnten Teil (104) aufweist.

2. Karte nach Anspruch 1, dadurch gekennzeichnet, daß der Schaltungsträger (20) eine flexible gedruckte Schaltung ist, wobei das Energieübertragungselement darauf entworfen worden ist.

3. Karte nach einem der Ansprüche 1 oder 2, dadurch gekennzeichnet, daß zumindest ein Energieübertragungselement (220) eine Spule ist

4. Karte nach einem der Ansprüche 1 bis 3, dadurch gekennzeichnet, daß zumindest ein Teil des zweiten Abschnitts des Lagerungsbodens ein Gebiet (250) mit Überdicke aufweist, so daß das Energieübertragungselement (220) praktisch damit in Kontakt steht.

## Claims

1. A microcircuit card comprising a card support (130) which has a cavity (101) in which a cover foil is fixed, which foil has a circuit support (20) and at least one circuit (210) arranged on a lower surface of the circuit support (20) facing towards the interior of the cavity, the circuit being provided opposite a first portion (103) of a bottom of the cavity, the circuit support (20) comprising on its lower surface at least one energy-transfer element (22) arranged opposite a second portion of the bottom of the cavity which is spatially separated from said first portion, characterized in that the second portion is arranged close to a lateral edge of the cavity and the bottom comprises at least one thinned part (104) situated between the first portion (103) and the second portion.

2. A card as claimed in Claim 1, characterized in that the circuit support (20) is a flexible printed circuit with the energy transfer element patterned thereon.

3. A card as claimed in any one of the Claims 1 and 2, characterized in that at least one energy transfer element (220) is a coil.

4. A card as claimed in any one of the Claims 1 to 3, characterized in that at least one part of the second portion of the bottom of the cavity has a region of increased thickness (250) such that the energy transfer element (220) is practically in contact therewith.
